# EUROPEAN PATENT APPLICATION

(11) **EP 4 769 949 A1**
(43) Date of publication of application: **01.07.2026**
(21) Application number: 25218327.2
(22) Date of filing: 25.11.2025
(51) Int. Cl.: H03K 19/00, H03K 19/0185

(54) **VARIABLE-SWING NMOS-OVER-NMOS DRIVER**

(30) Priority: 27.12.2024 US 202419003053
(71) Applicant: INTEL Corporation, Santa Clara, CA 95054 (US)
(72) Inventor: MANSURI, Mozhgan, Kalama, 98625-0047 (US); MONDAL, Susnata, Hillsboro (US); KUMAR, Aruna, KA 560076 Bangalore (IN); PASDAST, Gerald S., San Jose, CA 95120 (US)
(74) Representative: Viering, Jentschura & Partner mbB Patent- und Rechtsanwälte

(57) **Abstract**

Some embodiments include apparatuses and methods of making the apparatuses. One of the apparatuses includes: a first supply node (V2); a second supply node (140); and a driver (110). The driver includes a first input path (221), a second input path (222), an output node (205), a first N-type transistor (M1), a second N-type transistor (M2), and a resistor (M3). The first N-type transistor (M1) includes a gate coupled to the first input path, a first terminal coupled to the first supply node, and a second terminal coupled to the output node. The second N-type transistor includes a gate coupled to the second input path, a first terminal coupled to the output node, and a second terminal. The resistor is coupled between the second terminal of the second N-type transistor and the second supply node.

## Description

### BACKGROUND

Many electronic devices and computer systems have drivers to transmit or receive information (e.g., data) in the form of electrical signals. In some devices and systems, the signals are carried through wireline links between components of the devices or systems. Growing demand for system data traffic encourages the development of circuit techniques to enhance the energy efficiency of different wireline links. Examples of such wireline links include Universal Chiplet Interconnect Express die-to-die input/ouput (I/O) through standard (UCIe-S) and advanced (UCIe-A) package, off-package chip-to-chip I/O through either the top or bottom side of the package, Double Data Rate (DDR) synchronous dynamic random-access memory link, Low-Power DDR (LPDDR), Peripheral Component Interconnect Express (PCIe), electrical SerDes links, integrated or discrete optical links, high-bandwidth memory interfaces, and other links. A driver in transmitter circuitry is usually one of the most critical and challenging building blocks for such wireline links because the driver is often used to drive lossy off-chip channels with high output swing while consuming low power and providing termination matching to reduce reflection. Conventional voltage-mode drivers outperform current-mode drivers in energy efficiency. However, such conventional voltage-mode drivers still involve a significant trade-off between achievable output swing and power consumption.

### BRIEF DESCRIPTION OF THE DRAWINGS

FIG. 1 shows an apparatus including devices and drivers, according to some embodiments described herein.
FIG. 2 shows a driver of a device of FIG. 1, according to some embodiments described herein.
FIG. 3 shows a physical structure of a portion of the driver of FIG. 2, according to some embodiments described herein.
FIG. 4A is a graph showing an example eye diagram of signals at an output node of the driver of FIG. 2, according to some embodiments described herein.
FIG. 4B is a graph showing an example eye diagram of signals at an output node of a conventional driver, according to some embodiments described herein.
FIG. 5 shows a driver of including a variable supply voltage, according to some embodiments described herein.
FIG. 6 shows a driver including a tuning circuit, according to some embodiments described herein.
FIG. 7 is a flow diagram of an example method of operating a driver, according to some embodiments described herein.
FIG. 8 shows a block diagram of an example machine, according to some embodiments described herein.
FIG. 9 a flow diagram of an example process of making a driver, according to some embodiments described herein.

### DETAILED DESCRIPTION

The techniques described herein involve a voltage-mode driver in a wireline transmitter device. Many conventional voltage-mode drivers are available. However, some of those conventional drivers have drawbacks. For example, a conventional PMOS-over-NMOS driver may provide a relatively high output swing. However, such a conventional PMOS-over-NMOS driver often includes a resistor on the output path of the driver that is coupled to a conductive pad (e.g., the output pad of a transmitter). Such a resistor is often included to ensure linear region operation of pull-up PMOS and pull-down NMOS devices in the conventional PMOS-over-NMOS driver. Therefore, for a fixed driver resistance target, a fraction of resistance is actually realized by the active devices, necessitating significant driver size upscaling. The upscaled driver subsequently has a ripple effect in the chain, requiring preceding stages of the driver to be upsized by the same amount. This can significantly degrade overall power efficiency. Further, the upscaled driver also increases output node capacitance, degrading overall transmitter eye performance.

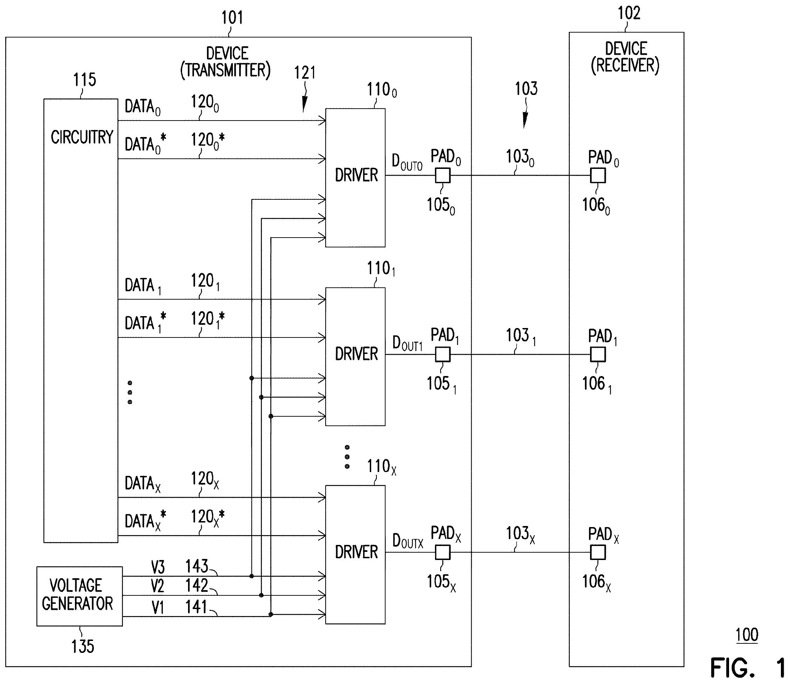

In another example, some conventional NMOS-over-NMOS drivers may use NMOS transistors in the output stage, such that a series-connected resistor may be omitted. In this example, the conventional NMOS-over-NMOS driver output stage often operate from a relatively lower driver supply voltage, and a relatively higher supply voltage in the pre-driver stage of the driver. This allows both the pull-up and pull-down path in the conventional NMOS-over-NMOS driver to operate in the linear region despite the omission of a series-connected resistor. This can improve transmitter energy efficiency. However, the conventional NMOS-over-NMOS driver may suffer from a relatively lower output swing due to lower driver supply voltage. In comparison with the mentioned conventional PMOS-over-NMOS driver, the conventional NMOS-over-NMOS driver has a tradeoff in which the conventional NMOS-over-NMOS driver can achieve energy-efficiency but suffers from a lower output swing. Thus, neither the described conventional NMOS-over-NMOS driver nor the conventional PMOS-over-NMOS driver is suitable for some high-speed wireline links, which often operate under high energy efficiency and high output swing. As described in more detail below, the described driver has higher energy efficiency and higher output swing in comparison with some conventional NMOS-over-NMOS drivers. These and other improvements and benefits of the described techniques are discussed in more detail below with reference to FIG. 1 through FIG. 9.

FIG. 1 shows an apparatus 100 including devices 101 and 102, according to some embodiments described herein. Apparatus 100 can include or be included in an electronic device or system, such as a computer (e.g., desktop, laptop, or notebook), a tablet, a cellular phone, a system on chip (SoC), a system in a package (SiP), or other electronic devices or systems. Each of devices 101 and 102 can include an integrated circuit (IC), such as an IC chip. Devices 101 and 102 can include a combination of a controller (e.g., processors (e.g., central processing unit (CPU)), graphics controller, input/output (I/O) controller, or memory controller, a memory device, and/or other electronic devices. In an example, apparatus 100 include an electronic package in which devices 101 and 102 are IC chips included in (e.g., co-located on) the electronic package.

As shown in FIG. 1, device 101 can include conductive pads 105₀ through 105x, which can include conductive I/O pads. Device 102 can include conductive pads 106₀ through 106_{X}, which can include conductive I/O pads. Conductive pads 105₀ through 105x and 106₀ through 106x can include conductive pins, conductive bumps, conductive balls, or other types of conductive connections. Conductive pads 105₀ through 105x and 106₀ through 106x allow respective devices 101 and 102 to communicate with each other in the form of electrical signals through an interconnect (e.g., physical channel) 103 coupled to conductive pads 105₀ through 105x and 106₀ through 106x.

As shown in FIG. 1, interconnect 103 can include lanes 103₀ through 103x to conduct signals between devices 101 and 102. Each of lanes 103₀ through 103_{X} can be a bi-directional lane to allow transmission of signals from device 101 to device 102 or from device 102 to device 101. Each of lanes 103₀ through 103x can include a single conductive line (or alternatively multiple conductive lines). The conductive line can include metal traces or other conductive connections. In example where devices 101 and 102 are included (e.g., co-located) on the same electronic package, lanes (e.g., conductive lines) 103₀ through 103x can be located on the electronic package. In another example, apparatus 100 can include a circuit board (e.g., printed circuit board), such that lanes 103₀ through 103x can include conductive traces (e.g., metal-based conductive traces) on the circuit board where devices 101 and 102 are located on the circuit board. In an alternative arrangement, interconnect 103 does not have to include conductive lines on a circuit board.

As shown in FIG. 1, device 101 can include drivers (e.g., output drivers) 110₀ through 110x having respective outputs (e.g., output nodes) coupled to respective conductive pads 105₀ through 105x to provide (e.g., output) information D_{OUT0} through D_{OUT}x to respective conductive pads 105₀ through 105x. Device 101 can include circuitry 115 that can include memory circuits (e.g., to store information) and other circuits (e.g., to provide control information).

Device 101 can include conductive lines (e.g., conductive nodes) 120₀/120₀* through 120x/120x* coupled to respective inputs (e.g., input nodes) 121 of drivers 110₀ through 110_{X} to provide respective information (e.g., input data information) DATA₀/DATA₀* through DATA_{X}/DATA_{X}* to drivers 110₀ through 110_{X}, respectively. Drivers D_{OUT0} through D_{OUT}x can operate to receive information DATA₀/DATA₀* through DATA_{X}/DATA_{X}* and provide (e.g., generate) information (e.g., output data information) D_{OUT0} through D_{OUT}x based on information DATA₀/DATA₀* through DATA_{X}/DATA_{X}*.

Conductive lines 120₀/120₀* through 120x/120x* can be called conductive line pairs. For example, conductive lines 120₀/120₀* can be called a conductive line pair (two separate conductive lines) 120₀/120₀*. Similarly, conductive lines 120₁/120₁* can be called a conductive line pair (two separate conductive lines) 120₁/120₁*.

Information DATA₀/DATA₀* through DATA_{X}/DATA_{X}* can be digital information (digital data). The digital information can be represented by differential signals associated with DATA₀/DATA₀* through DATA_{X}/DATA_{X}*. For example, information DATA₀/DATA₀* can be digital information represented by a differential signal pair. As an example, information DATA₀ (carried by a signal on conductive line 120₀) can have a value corresponding to a binary 0, and information DATA₀* (carry by a signal on conductive line 120₀*) can have a value corresponding to a binary 1. In this example, information DATA₀ can be represented by a signal (part of a differential signal pair) having one value (e.g., a lower signal level corresponding to binary 0), and information DATA₀* can be represented by another signal (another part of a differential signal pair) having another value (e.g., a higher signal level corresponding to binary 1). The signal levels (e.g., lower and higher signal levels) described here are based on voltage values of supply nodes (e.g., nodes 141, 142, and 143) coupled to drivers 110₀ through 110x.

As shown in FIG. 1, device 101 can include a voltage generator 135 to generate voltages V1, V2, and V3 at respective nodes (e.g., supply nodes) 141, 142, and 143. Each of nodes 141, 142, and 143 can be called a positive voltage connection. Voltages V1, V2, and V3 can have different values (positive voltage values). Voltage V3 is greater than voltage V2, and voltage V2 is greater than voltage V1 (V1 < V2 < V3).

In the description herein, each of voltages V1, V2, and V3 can have values of less than one volt (e.g., (V1 < V2 < V3 < 1V). As an example, voltage V1 can have a range from 0.5V to 0.7V. Voltages V2 and V3 can have values of 0.7V and 0.85V, respectively. However, other voltage values can be used.

Device 101 can provide some or all of voltages V1, V2, and V3 to drivers 110₀ through 110x. Drivers 110₀ through 110x can be coupled to nodes (e.g., supply nodes) 141, 142, and 143 and use voltages V1, V2, and V3 as supply voltages (e.g., operating voltages).

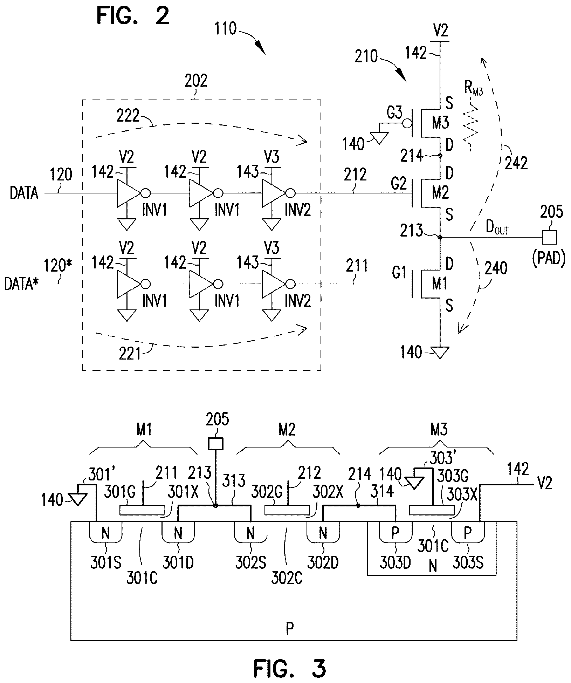

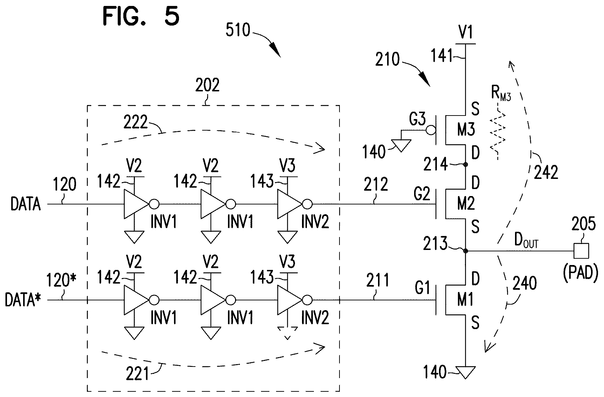

Device 101 can have different modes (operating modes). For example, device 101 can have a mode where drivers 110₀ through 110_{X} may be coupled to nodes 142 and 143 (as shown in FIG. 2) and use voltages V2 and V3 as supply voltages. In another example, device 101 can have another mode (can switch to another mode) where drivers 110₀ through 110_{X} may be coupled to nodes 141, 142, and 143 (e.g., as shown in FIG. 5) and use voltages V1, V2, and V3 as supply voltages.

FIG. 2 shows a driver 110 including N-type transistors M1 and M2, according to some embodiments described herein. Driver 110 can represent (e.g., can be) one of drivers 110₀ through 110x of FIG. 1. Conductive line pair (e.g., conductive nodes) 120/120* in FIG. 2 can represent one of conductive line pair 120₀/120₀* through conductive line pair 120x/120x* of FIG. 1. Information DATA/DATA* in FIG. 2 can represent one of information DATA₀/DATA₀* through DATA_{X}/DATA_{X}* of FIG. 1. Information DATA/DATA* can be digital information. For example, information DATA (carried by a signal on conductive line 120) can have a value corresponding to a binary 0, and information DATA* (carried by a signal on conductive line 120*) can have a value corresponding to a binary 1. In another example, information DATA can have a value corresponding to a binary 1, and information DATA* can have a value corresponding to a binary 0.

As shown in FIG. 2, driver 110 can include input paths (e.g., input circuits) 221 and 222 coupled to nodes 120* and 120, respectively. Each of input paths 221 and 222 can include respective inverters (inverter circuits) INV1 and INV2 coupled in series with each other. Inverters INV1 and INV2 can have similar (or the same elements (e.g., transistors)). However, as shown in FIG. 2, inverters INV1 can be coupled to node 142 to receive voltage V2. Inverters INV2 can be coupled to node 143 to receive voltage V3. Input paths 221 and 222 (including inverters INV1 and INV2) can be part of a pre-driver stage 202 of driver 110. Input paths 221 and 222 have the same numbers of inverters (e.g., three inverters INV1, INV1, and INV2 in FIG. 2). FIG. 2 shows driver 110 including three inverters (inverter INV1, INV1, and INV2) in each of input paths 221 and 222 as an example. However, input paths 221 and 222 can have a different number of inverters.

As shown in FIG. 2, driver 110 can include transistors M1, M2, and M3 coupled in series with each other between a node 140 and node 142. Node 140 can be a supply node that is coupled to ground (e.g., ground connection). For simplicity, other nodes 140 (ground symbols in input paths 221 and 222) are not labeled. Driver 110 can include a pull-up path 242 between nodes 213 and 142 that includes transistors M2 and M3. Driver 110 can include a pull-down path 240 between nodes 213 and 140 that includes transistors M1.

Transistors M1 and M2 can include N-type transistors. An example of an N-type transistor includes N-type FET, such as N-type metal-oxide semiconductor (NMOSFET or NMOS). Other N-type transistors can be used for transistor M1 and M2. Transistor M3 include a P-type transistors. An example of a P-type transistor includes a P-type field-effect transistor (FET), such as P-type metal-oxide semiconductor (PMOSFET or PMOS). Other P-type transistors can be used for transistor M3.

As shown in FIG. 2, transistors M1, M2, and M3 can be part of (can be included in) an output circuit (e.g., output stage) 210 of driver 110. Output circuit 210 can include nodes (e.g., input nodes) 211 and 212 coupled to input paths 221 and 222, respectively, to receive information (e.g., input information) DATA and DATA*, respectively. Output circuit 210 can also include output node 213 coupled to (e.g., directly coupled to) conductive pad 205. Output circuit 210 can provide information (e.g., output data information) D_{OUT} from node 213 to conductive pad 205. The value of information D_{OUT} is based on the values of information DATA and DATA*. For example, information D_{OUT} can have a value (digital value) corresponding to a binary 0 when information DATA and DATA* have values corresponding to a binary 1 and binary 0, respectively. In another example, information D_{OUT} can have a value (digital value) corresponding to a binary 1 when information DATA and DATA* have values corresponding to a binary 0 and binary 1, respectively.

As shown in FIG. 2, transistor M1 can include a gate G1 coupled to input path 221 at node 211, a terminal S (e.g., a source) coupled to node 140, and a terminal D (e.g., a drain) coupled to node 213. In this description, source and drain of a transistor (e.g., transistor M1 or M2) are used interchangeably.

Transistor M2 can include a gate G2 coupled to input path 222 at node 212, a terminal S (e.g., a source) coupled to node 213, and a terminal D (e.g., a drain) coupled to a node 214, which is coupled to a terminal D (e.g., drain) of transistor M3. Transistor M3 also include a gate G3 coupled to node (e.g., ground connection) 140, and a terminal S (e.g., a source) coupled to node (e.g., supply node) 142.

As shown in FIG. 2, since gate G3 of transistor M3 is coupled to node 140 (e.g., is fixed at ground potential at node 140), transistor M3 is turned on during operation of driver 110. Transistor M3 can operate in the linear region during operation of driver 110. The configuration (structure and connections) of transistor M3 allows transistor M3 to operate (e.g., to form) a resistor, such as resistor R_{M3}. Thus, driver 110 can include a resistor (e.g., resistor R_{M3}) coupled between node 214 (coupled to terminal D of transistor M2) and node (e.g., supply node) 142, in which the resistor includes (e.g., is implanted as) a structure of a p-type transistor (e.g., transistor M3).

FIG. 3 shows a structure (physical structure) of part of driver 110 of FIG. 2, according to some embodiments described herein. As shown in FIG. 3, driver 110 can include regions 301S and 301D, a region 301C between regions 301S and 301D, and a conductive region 301G separated from region 301C by a dielectric region 301X. Each of regions 301S and 301D can include a semiconductor (e.g., polysilicon) material of N-type (N-type conductivity, labeled "N" in FIG. 3). Regions 301C can include a semiconductor (e.g., polysilicon) material of P-type (P-type conductivity, labeled "P" in FIG. 3). Conductive region 301G can include conductively-doped polysilicon, metal, or other conductive materials. Dielectric region 301X can include silicon dioxide or other dielectric materials. Dielectric region 301X can part of a gate oxide of transistor M1.

Driver 110 can include regions 302S, 302D, a region 302C between regions 302S and 302D, and a conductive region 302G separated from region 302C by a dielectric region 302X. Each of regions 302S and 302D can include a semiconductor (e.g., polysilicon) material of N-type (N-type conductivity, labeled "N" in FIG. 3). Regions 302C can include a semiconductor (e.g., polysilicon) material of P-type (P-type conductivity, labeled "P" in FIG. 3). Conductive region 302G can include conductively-doped polysilicon, metal, or other conductive materials. Dielectric region 302X can include silicon dioxide or other dielectric materials. Dielectric region 302X can part of a gate oxide of transistor M2.

Driver 110 can include regions 303S, 303D, a region 303C between regions 303S and 303D, and a conductive region 303G separated from region 303C by a dielectric region 303X. Each of regions 303S and 303D can include a semiconductor (e.g., polysilicon) material of P-type (P-type conductivity, labeled "P" in FIG. 3). Regions 303C can include a semiconductor (e.g., polysilicon) material of N-type (N-type conductivity, labeled "N" in FIG. 3). Conductive region 303G can include conductively-doped polysilicon, metal, or other conductive materials. Dielectric region 303X can include silicon dioxide or other dielectric materials. Dielectric region 303X can part of a gate oxide of transistor M3.

As shown in FIG. 3, regions 301S and 303S can be coupled to nodes 140 and 142, respectively, through conductive connections (e.g., metal routings) 301' and 303', respectively. Regions 301G and 302G can be coupled to nodes 211 and 212, respectively. Region 303G can be coupled to node 140. Regions 301D and 302S can be coupled to each other to node 213, which is coupled to conductive pad 205. Regions 301D and 302S can be coupled to each other through a conductive connection 313, which is coupled to node 213 and conductive pad 205. Regions 302D and 303D can be coupled to each other through a conductive connection 314, which is coupled to node 214.

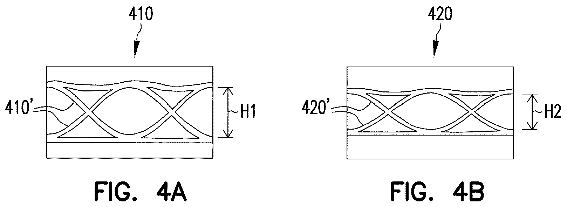

FIG. 4A is a graph showing an example eye diagram 410 of the signal at node (e.g., output node) 213 of driver 110 of FIG. 2, according to some embodiments described herein. FIG. 4B is a graph showing an example eye diagram 420 at an output node of a conventional NMOS-over-NMOS driver. Eye diagram 410 is based on a simulation associated with an example UCIe link coupled to driver 110. Voltages V2 and V3 in the example of FIG. 4A have example values of 0.7V and 0.85V) respectively. In FIG. 4A, eye diagram 410 represents signals 410' associated information D_{OUT} at node 213 (at conductive pad 205) in FIG. 2. Eye diagram 410 in FIG. 4A represents the signals 420' associated information at an output node (not shown) of a conventional driver (not shown). As shown in FIG. 4A, eye diagram 410 has an eye heighT (measured in volt unit) H1. Eye diagram 420 has an eye height (measured in volt unit) H2 that is less than eye height H1 (H2 < H1). Eye heights H1 and H2 can represent output swings of signals 410' and 420', respectively. Thus, as shown in FIG. 4A and FIG. 4B, the output swings (eye height H1) of driver 110 is greater than the output swing of a conventional NMOS-over-NMOS driver. Operations and improvement and benefits of driver 110 are described below.

Driver 110 can mitigate the conventional trade-off between swing and power consumption. During operation of driver 110, transistor M3 operates in a linear region as a resistor to resistance in pull-up path 242. This allows for high-swing driver operation by using a relatively higher supply voltage (e.g., voltage V2 at 0.7V). The resistance of pull-up path 242 can be achieved through a combination of the resistances provided by transistor M3 and transistor M2. The ratio of the resistances provided by transistors M3 and M2 can be selected (e.g., optimized) for the specific supply voltage conditions, application, and process technology. The size of transistor M3 can be greater than the size of transistors M2. The size of transistor M2 can be greater than the size of transistors M1. The size of a transistor can be measured by transistor channel length, transistor channel width, or both. As an example, in UCIe link, an example ratio of transistor M3 to transistor M2 can be a 2:1 ratio (e.g., transistor M3 is two times bigger than transistor M2). As shown in FIG. 2, gate G3 of transistor M3 is coupled to node 140 (gate G3 is grounded). This can improve (e.g., maximize) the linearity of the resistor (R_{M3}) provided by transistor M3. When pull-up path 242 is activated, current flows through transistors M3 and M2 and the termination resistor (not shown) of device 102. This forces the node 214 (the drain of transistor M2) below voltage V2, thereby ensuring the linear region operation of transistor M2. This configuration can eliminate a resistor between node 213 and conductive pad 205, such that as shown in FIG. 2, node 213 can be directly coupled to conductive pad 205. Thus, in comparison with some conventional drivers (e.g., PMOS-over-NMOS drivers), driver 110 can omit (can be formed without) a resistor between node 213 and conductive pad 205, as shown in FIG. 2 and still enable a higher driver supply voltage (e.g., voltage V2 = 0.7V).

In operation of driver 110, transistor M3 only conducts (is turned on) when transistor M2 is active, which ensures that the combined resistance of transistors M2 and M3 operates as a single linearized pull-up resistor (on pull-up path 242) from a relatively higher supply voltage (e.g., voltage V2) at node 142. This allows driver 110 to facilitate high-swing operation. To operate at a relatively high value of voltage V2 (e.g., V2 > 0.7V) for achieving a relatively higher swing (e.g., higher swing than that of the example of FIG. 4A), the driver input signals (e.g., the signals associated with information DATA and DATA*) can be boosted to a higher voltage (by adjusting voltage V2 or V3 or both). Alternatively, the ratio R_{M3}:R_{M2} (where R_{M2} is the resistance provided by transistor M2) can be increased to create a larger voltage drop across transistor M3 to ensure that transistor M2 operates in the linear region.

FIG. 5 shows a driver 510 including a voltage V1, according to some embodiments described herein. As shown in FIG. 5, driver 510 includes elements that are similar to or the same as the elements of driver 110 of FIG. 2. Thus, for simplicity, descriptions of similar or the same elements between drivers 110 and 510 are not repeated. In FIG. 5, driver 510 can support a variable-swing through the selection of voltage V1 (one of the supply voltages of drivers 510) at node 141. Voltage V1 can be a variable voltage (e.g., can be adjusted) to provide target output swing. In comparison with driver 110 of FIG. 2, voltage V1 (at node 141 in FIG. 5) can be not greater than voltage V2 (at node 142 in FIG. 2). In an example, voltage V1 can have a range from 0.5V to 0.7V, which is not greater than voltage V2 (e.g., V2 = 0.7V).

When the driver 510 operates at a relatively reduced voltage (e.g., at V1 < V2) in comparison with driver 110, driver 510 can also support low-swing operation, thereby improving energy efficiency. In comparison with driver 110 of FIG. 2, since voltage V1 is less than voltage V2, the turn-on resistance (R_{M3}) of transistor M3 increases due to lower gate-to-source voltage (V_{GS}), and the resistance (R_{M2}) of transistor M2 decreases due to higher voltage V_{GS} (at the low transistor M2 source supply). This helps maintain the effective resistance of pull-up path 242 within a relatively small percentage of variation bound (e.g., < 7% resistance change from voltage V2 (e.g., V2 = 0.7V) to voltage V1 (e.g., V1 = 0.5V). In an example, the eye diagram (not shown) of the signals at node 213 of driver 510 can be similar to eye diagram 410 of FIG. 4A. However, the eye height (not shown) of driver 510 is less eye height H1 (FIG. 4A) of driver 110, indicating that driver 510 can have a lower output swing than driver 110 of FIG. 2. A lower output swing can improve energy efficiency.

Thus, as described above, driver 110 and 510 can have the same structure. However, the ability of operating drivers 110 and 510 at different supply voltages (to obtain a variable output swing) provides a significant advantage over conventional wireline drivers. This allows the same structure of the driver (e.g., drivers 110 and 510) to support different specifications (e.g., high output swing or low output swing) associated with different specifications of a particular communication link (e.g., specifications associated with at least one of channel length, data-rate, driver components (e.g., silicon), and other specifications).

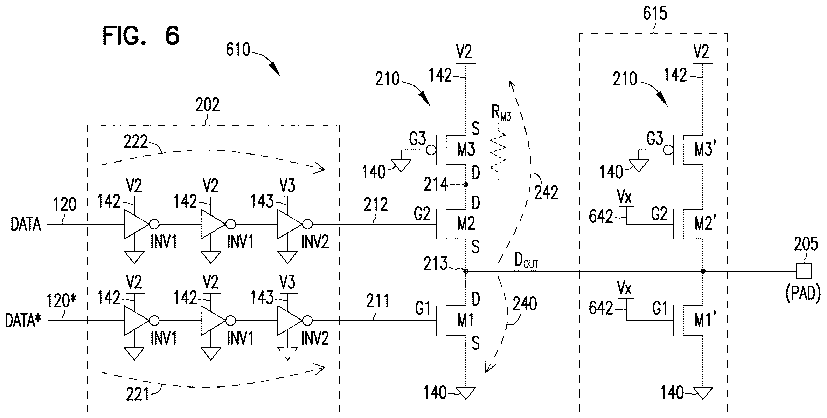

FIG. 6 shows a driver 610 including tuning circuit 615, according to some embodiments described herein. As shown in FIG. 6, driver 610 includes elements that are similar to or the same as the elements of driver 110 of FIG. 2. Thus, for simplicity, descriptions of similar or the same elements between drivers 110 and 610 are not repeated. In FIG. 6, voltage V2 (e.g., supply voltage of driver 610) and voltage V3 (e.g., pre-driver supply voltage) for driver 110 can be independently selected. Wireline links often have support for backward compatibility (e.g., support a lower data rates) with previous generations. To maintain or improve link energy efficiency at a lower data rate (with relaxed eye margins), supply voltage scaling can be often used as a powerful tuning knob. In FIG. 6, voltages V2 and V3 of driver 110 can be concurrently (e.g., simultaneously) scaled to improve energy efficiency at a lower data rate. For example, in comparison with voltages V2 (e.g., V2 = 0.7V) and voltage V3 (e.g., V3 = 0.85V) of driver 110 of FIG. 2, voltages V2 in FIG. 6 can be scaled from 0.7V to 0.5V, and voltage V3 in FIG. 6 can be scaled from 0.85 to 0.7V. In FIG. 6, as the supply voltage is scaled, the resistance of pull-up path 242 and the resistance of pull-down 240 increase (e.g., increased by 10-15% this example). However, the resistances of pull-up path 242 and pull-down path 240 can remain unchanged (e.g., can be untuned) due to a better margin at a lower rate. This means that tuning circuit 615 can be omitted from driver 610 of FIG. 6.

Alternatively, as shown in FIG. 6, tuning circuit (termination tuning circuit) 615 can be included in driver 610 to provide tuning of the resistances of pull-up and pull-down paths 242 and 240. This allows further improvement in energy efficiency of driver 610 in comparison with driver 110 of FIG. 2.

As shown in FIG. 6, tuning circuit 615 can include transistors M1', M2', and M3' coupled to nodes (e.g., supply nodes) 140 and 142 and node (e.g., output node) 213 of driver 610 in ways like transistors M1, M2, and M3 of FIG. 2. As shown in FIG. 6, the gate of transistor M3' is connected to node 140 (e.g., ground), the gate of transistors M1' and M2' can be coupled to a voltage Vx at a node (e.g., supply node) 642 to allow transistors M1, M2, and M3 to operate as resistors. These resistors allow tuning circuit 615 to provide active-based resistor branches (provided by transistors M1, M2, and M3). In comparison with driver 110 of FIG. 2, the output node capacitance of driver 610 can be negligibly higher (e.g., approximately 2% higher). However, supply voltage scaling of driver 610 can significantly improves energy efficiency at the lower data rate.

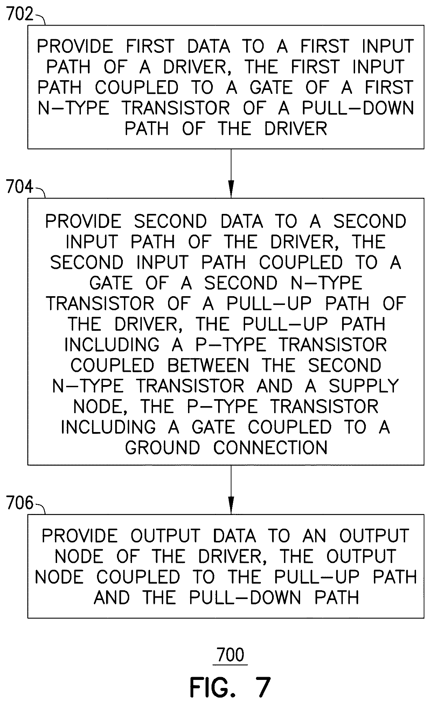

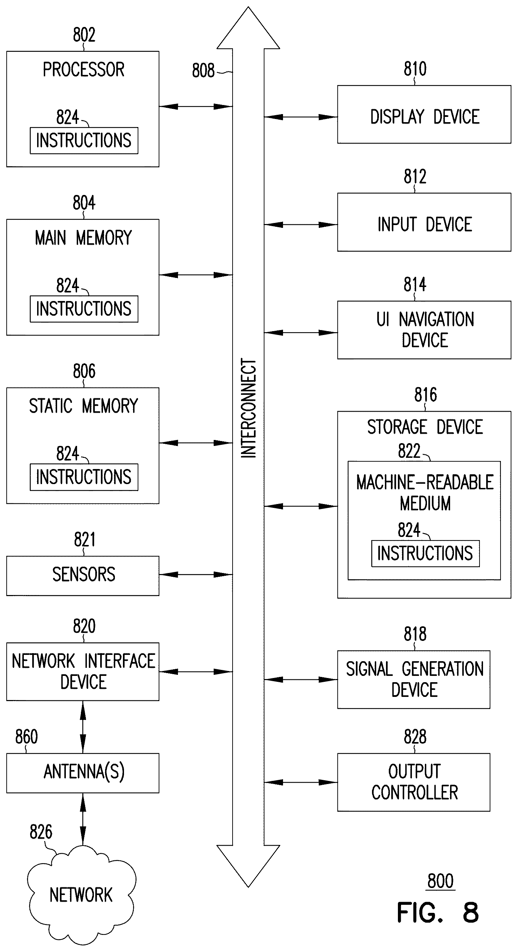

FIG. 7 is a flow diagram of an example method 700 of operating a driver of a device, according to some embodiments described herein. The driver associated with method can include driver 110, 510, or 610 described above. As shown in FIG. 7, method 700 can include operations 702, 704, and 706 that may be executed by an embedded controller or another processor of a computing device (e.g., hardware processor 802 of machine 800 illustrated in FIG. 8, which can include one or more of the circuits discussed in connection with FIG. 1 through FIG. 8. In some embodiments, one or more of the circuits discussed in connection with FIG. 1 through FIG. 8 can perform the functionalities (e.g., operations) shown in FIG. 7 and in the examples listed below.

Operation 702 can include providing first data (e.g., information DATA*) to a first input path (e.g., input path 221) of the driver. The first input path is coupled to a gate of a first N-type transistor (e.g., transistor M1) of a pull-down (e.g., pull-down path 240) path of the driver.

Operation 704 can include providing second data (e.g., information DATA) to a second input path (e.g., input path 222) of the driver. The second input path is coupled to a gate of a second N-type transistor (e.g., transistor M2) of a pull-up (e.g., pull-up path 242) path of the driver.

Operation 706 can include providing output data (e.g., information D_{OUT}) to an output node (e.g., node 213) of the driver. The output node is coupled to the pull-up path and the pull-down path of the driver. The output node of the driver can also be directly coupled to a conductive pad (e.g., conductive pad 205) of a device (e.g., device 101) that includes the driver.

Method 700 can include fewer or more operations than the operations shown in FIG. 7. For example, method 700 can include operations of apparatus 100 including operations of driver 110, 510, and 610. Method 700 can also include operations described in the examples listed below.

FIG. 8 shows a block diagram of an apparatus in the form of an example machine (e.g., an electronic system) 800 upon which any one or more of the techniques (e.g., methodologies) discussed herein may perform. In alternative embodiments, the machine 800 may operate as a standalone device or may be connected (e.g., networked) to other machines. In a networked deployment, machine 800 may operate in the capacity of a server machine, a client machine, or both in server-client network environments. In an example, machine 800 may function as a peer machine in a peer-to-peer (P2P) (or other distributed) network environment. The machine 800 may be a personal computer (PC), a tablet PC, a set-top box (STB), a personal digital assistant (PDA), a portable communications device, a mobile telephone, a smartphone, a web appliance, a network router, switch or bridge, or any other computing device capable of executing instructions (sequential or otherwise) that specify actions to be taken by that machine. Further, while only a single machine is shown, the term "machine" shall also be taken to include any collection of machines that individually or jointly execute a set (or multiple sets) of instructions to perform any one or more of the methodologies discussed herein, such as cloud computing, software as a service (SaaS), other computer cluster configurations. The terms "machine," "computing device," and "computer system" are used interchangeably.

The apparatus including machine 800 may be configured to perform one or more of the methods and/or operations disclosed herein. The apparatus may be intended as a component of machine 800 to perform one or more of the methods and/or operations disclosed herein and/or to perform a portion of one or more of the methods and/or operations disclosed herein. In some embodiments, the apparatus may include a pin or other means to receive power. In some embodiments, the apparatus may include power conditioning hardware.

Machine (e.g., computer system) 800 may include a hardware processor 802 (e.g., a central processing unit (CPU), a graphics processing unit (GPU), a hardware processor core, or any combination thereof), a main memory 804, and a static memory 806, some or all of which may communicate with each other via an interconnect (e.g., bus) 808. In some aspects, main memory 804, static memory 806, or any other type of memory (including cache memory) used by machine 800 can be configured based on the disclosed techniques or can implement the disclosed memory devices.

Specific examples of main memory 804 include Random Access Memory (RAM) and semiconductor memory devices, which may include, in some embodiments, storage locations in semiconductors such as registers. Specific examples of static memory 806 include non-volatile memory, such as semiconductor memory devices (e.g., Electrically Programmable Read-Only Memory (EPROM), Electrically Erasable Programmable Read-Only Memory (EEPROM)) and flash memory devices; magnetic disks, such as internal hard disks and removable disks; magneto-optical disks; RAM; and CD-ROM and DVD-ROM disks.

Machine 800 may further include a display device 810, an input device 812 (e.g., a keyboard), and a user interface (UI) navigation device 814 (e.g., a mouse). In an example, display device 810, input device 812, and UI navigation device 814 may be a touchscreen display. The machine 800 may additionally include a storage device (e.g., drive unit or another mass storage device) 816, a signal generation device 818 (e.g., a speaker), a network interface device 820, and one or more sensors 821, such as a global positioning system (GPS) sensor, compass, accelerometer, or other sensors. Machine 800 may include an output controller 828, such as a serial (e.g., universal serial bus (USB), parallel, or other wired or wireless (e.g., infrared (IR), near field communication (NFC), etc.) connection to communicate or control one or more peripheral devices (e.g., a printer, card reader, etc.). In some embodiments, hardware processor 802 and/or instructions 824 may comprise processing circuitry and/or transceiver circuitry.

Storage device 816 may include a machine-readable medium 822 on which one or more sets of data structures or instructions 824 (e.g., software) embodying or utilized by any one or more of the techniques or functions described herein can be stored. Instructions 824 may also reside, completely or at least partially, within the main memory 804, within static memory 806, or hardware processor 802 during execution thereof by machine 800. In an example, one or any combination of hardware processor 802, main memory 804, static memory 806, or storage device 816 may constitute machine-readable media.

Specific examples of machine-readable media may include non-volatile memory, such as semiconductor memory devices (e.g., EPROM or EEPROM) and flash memory devices; magnetic disks, such as internal hard disks and removable disks; magneto-optical disks; RAM; and CD-ROM and DVD-ROM disks.

FIG. 8 shows the machine-readable medium 822 as a single medium as an example. However, the term "machine-readable medium" may include a single medium or multiple media (e.g., a centralized or distributed database and/or associated caches and servers) configured to store instructions 824.

The term "machine-readable medium" may include any medium that is capable of storing, encoding, or carrying instructions for execution by machine 800 and that causes machine 800 to perform any one or more of the techniques of the present disclosure or that is capable of storing, encoding, or carrying data structures used by or associated with such instructions. Non-limiting machine-readable medium examples may include solid-state memories and optical and magnetic media. Specific examples of machine-readable media may include non-volatile memory, such as semiconductor memory devices (e.g., Electrically Programmable Read-Only Memory (EPROM), Electrically Erasable Programmable Read-Only Memory (EEPROM)) and flash memory devices; magnetic disks, such as internal hard disks and removable disks; magneto-optical disks; Random Access Memory (RAM); and CD-ROM and DVD-ROM disks. In some examples, machine-readable media may include non-transitory machine-readable media. In some examples, machine-readable media may include machine-readable media that is not a transitory propagating signal.

Instructions 824 may further be transmitted or received over a communications network 826 using a transmission medium via network interface device 820 utilizing any one of several transfer protocols (e.g., frame relay, internet protocol (IP), transmission control protocol (TCP), user datagram protocol (UDP), hypertext transfer protocol (HTTP), etc.). Example communication networks may include a local area network (LAN), a wide area network (WAN), a packet data network (e.g., the Internet), mobile telephone networks (e.g., cellular networks), Plain Old Telephone (POTS) networks, and wireless data networks (e.g., Institute of Electrical and Electronics Engineers (IEEE) 302.11 family of standards known as Wi-Fi^{®}, IEEE 302.16 family of standards known as WiMax^{®}), IEEE 302.8.4 family of standards, a Long Term Evolution (LTE) family of standards, a Universal Mobile Telecommunications System (UMTS) family of standards, peer-to-peer (P2P) networks, among others.

In an example, network interface device 820 may include one or more physical jacks (e.g., Ethernet, coaxial, or phone jacks) or one or more antennas to connect to communications network 826. In an example, network interface device 820 may include a connector, in which the connector conforms with at least one of Universal Serial Bus (USB), High-Definition Multimedia Interface (HDMI), Thunderbolt, PCIe, UCIe, Ethernet, Double Data Rate (DDR) synchronous dynamic random-access memory link, Low-Power DDR (LPDDR), and Fiber Optic specifications. In an example, network interface device 820 may include one or more antennas 860 to wirelessly communicate using at least one single-input multiple-output (SIMO), multiple-input multiple-output (MIMO), or multiple-input single-output (MISO) techniques. In some examples, network interface device 820 may wirelessly communicate using multiple-user MIMO techniques. The term "transmission medium" shall be taken to include any intangible medium that can store, encode, or carry instructions for execution by machine 800 and includes digital or analog communications signals or other intangible media to facilitate communication of such software.

Examples, as described herein, may include, or may operate on, logic or several components, modules, or mechanisms. Modules are tangible entities (e.g., hardware) capable of performing specified operations and may be configured or arranged in a particular manner. In an example, circuits may be arranged (e.g., internally or concerning external entities such as other circuits) in a specified manner as a module. In an example, the whole or part of one or more computer systems (e.g., a standalone, client, or server computer system) or one or more hardware processors may be configured by firmware or software (e.g., instructions, an application portion, or an application) as a module that operates to perform specified operations. In an example, the software may reside on a machine-readable medium. In an example, the software, when executed by the underlying hardware of the module, causes the hardware to perform the specified operations.

Accordingly, the term "module" is understood to encompass a tangible entity, be that an entity that is physically constructed, specifically configured (e.g., hardwired), or temporarily (e.g., transitorily) configured (e.g., programmed) to operate in a specified manner or to perform part, all, or any operation described herein. Considering examples in which modules are temporarily configured, each of the modules need not be instantiated at any one moment in time. For example, where the modules comprise a general-purpose hardware processor configured using the software, the general-purpose hardware processor may be configured as respective different modules at separate times. The software may accordingly configure a hardware processor, for example, to constitute a particular module at one instance of time and to constitute a different module at a different instance of time.

Some embodiments may be implemented fully or partially in software and/or firmware. This software and/or firmware may take the form of instructions contained in or on a non-transitory computer-readable storage medium. Those instructions may then be read and executed by one or more processors to enable the performance of the operations described herein. The instructions may be in any suitable form, such as but not limited to source code, compiled code, interpreted code, executable code, static code, dynamic code, and the like. Such a computer-readable medium may include any tangible non-transitory medium for storing information in a form readable by one or more computers, such as but not limited to read-only memory (ROM), random access memory (RAM), magnetic disk storage media, optical storage media, flash memory, etc.

The above-detailed description includes references to the accompanying drawings, which form a part of the detailed description. The drawings show, by way of illustration, specific embodiments that may be practiced. These embodiments are also referred to herein as "examples." Such examples may include elements in addition to those shown or described. However, examples that include the elements shown or described are also contemplated. Moreover, also contemplated are examples using any combination or permutation of those elements shown or described (or one or more aspects thereof), either with respect to a particular example (or one or more aspects thereof) or with respect to other examples (or one or more aspects thereof) shown or described herein.

The embodiments as described above may be implemented in various hardware configurations that may include a processor for executing instructions that perform the techniques described. Such instructions may be contained in a machine-readable medium such as a suitable storage medium or a memory or other processor-executable medium.

The embodiments as described herein may be implemented in several environments, such as part of an IC chip, a system (e.g., a system in the form of machine 800, a system on chip, a system-in-package, a system-on-package, or a combination of these systems), a set of intercommunicating functional blocks, or similar, although the scope of the disclosure is not limited in this respect.

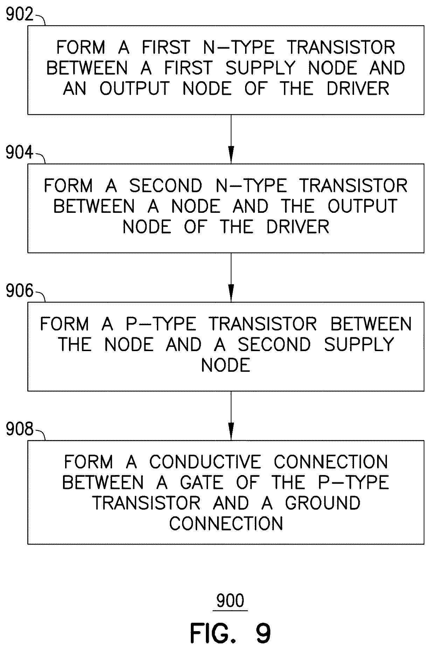

FIG. 9 is a flow diagram of an example process 900 that includes a process of making an apparatus that includes a making a device and a driver, according to some embodiments described herein. The apparatus associated with process 900 can include apparatus 100 of FIG. 1 or machine 800 of FIG. 8. The device associated with process 900 can include any of the devices and drivers (e.g., device 101 and drivers 110, 510, and 610) described above with reference to FIG. 1 through FIG. 8.

As shown in FIG. 9, process 900 can include activities 902, 904, 906, and 908. Activity 902 can include forming a first N-type transistor (e.g., transistor M1) between a first supply node (e.g., node 140) and an output node (e.g., node 213) of the driver. Activity 904 can include forming a second N-type transistor (e.g., transistor M2) between a node (e.g., node 214) and the output node of the driver. Activity 906 can include forming a P-type transistor (e.g., transistor M3) between the node (e.g., node 214) and a second supply node (e.g., node 142). Activity 908 can include forming a conductive connection (e.g., conductive connection 303') between a gate of the P-type transistor and a ground connection (e.g., at node 140).

Activities 902, 904, 906, and 908 can be performed in an order different from the order shown in FIG. 9. Process 900 can include fewer or more activities than the activities shown in FIG. 9. For example, process 900 can include forming other elements of the apparatus (e.g., the elements described above with reference to FIG. 1 through FIG. 8). Process 900 can also include activities described in the examples listed below.

In the detailed description and the claims, the term "on" used with respect to two or more elements (e.g., materials), one "on" the other, means at least some contact between the elements (e.g., between the materials). The term "over" means the elements (e.g., materials) are in close proximity, but possibly with one or more additional intervening elements (e.g., materials) such that contact is possible but not required. Neither "on" nor "over" implies any directionality as used herein unless stated as such.

In the detailed description and the claims, the term "adjacent" generally refers to a position of a thing being next to (e.g., either immediately next to or close to with one or more things between them) or adjoining another thing (e.g., abutting it or contacting it (e.g., directly coupled to) it).

In the detailed description and the claims, the terms "first", "second", and "third," etc. are used merely as labels, and are not intended to impose numerical requirements on their objects.

In the detailed description and the claims, a list of items joined by the term "at least one of" can mean any combination of the listed items. For example, if items A and B are listed, then the phrase "at least one of A and B" means A only; B only; or A and B. In another example, if items A, B, and C are listed, then the phrase "at least one of A, B and C" means A only; B only; C only; A and B (excluding C); A and C (excluding B); B and C (excluding A); or all of A, B, and C. Item A can include a single element or multiple elements. Item B can include a single element or multiple elements. Item C can include a single element or multiple elements.

In the detailed description and the claims, a list of items joined by the term "one of" can mean only one of the list items. For example, if items A and B are listed, then the phrase "one of A and B" means A only (excluding B), or B only (excluding A). In another example, if items A, B, and C are listed, then the phrase "one of A, B and C" means A only; B only; or C only. Item A can include a single element or multiple elements. Item B can include a single element or multiple elements. Item C can include a single element or multiple elements.

Described implementations of the subject matter can include one or more features, alone or in combination, as illustrated below by way of examples.

Example 1 is electronic apparatus comprising a first supply node, a second supply node, and a driver including a first input path, a second input path, and an output node, a first N-type transistor including a gate coupled to the first input path, a first terminal coupled to the first supply node, and a second terminal coupled to the output node, a second N-type transistor including a gate coupled to the second input path, a first terminal coupled to the output node, and a second terminal, and a resistor coupled between the second terminal of the second N-type transistor and the second supply node.

In Example 2, the subject matter of Example 1 includes subject matter wherein the resistor includes a structure of a P-type transistor, the P-type transistor includes a gate coupled to the first supply node, a first terminal coupled to the second terminal of the second N-type transistor, and a second terminal coupled to the second supply node.

In Example 3, the subject matter of Example 2 includes subject matter wherein the P-type transistor has a size greater than a size of the second N-type transistor.

In Example 4, the subject matter of Examples 2-4 includes subject matter wherein the second N-type transistor has a size greater than a size of the first N-type transistor.

In Example 5, the subject matter of Examples 2-3 includes subject matter wherein the P-type transistor is configured to operate in a linear region.

In Example 6, the subject matter of Examples 2-4 includes a first additional N-type transistor including a gate coupled to an additional supply node, a first terminal coupled to the first supply node, and a second terminal coupled to the output node, a second additional N-type transistor including a gate coupled to the additional supply node, a first terminal coupled to the output node, and a second terminal, and an additional P-type transistor including a gate coupled to the first supply node, a first terminal coupled to the second terminal of the second additional N-type transistor, and a second terminal coupled to the second supply node.

In Example 7, the subject matter of Examples 1-5 includes subject matter wherein the first input path includes a first inverter, and the second input path includes a second inverter.

In Example 8, the subject matter of Example 7 includes subject matter wherein each of the first inverter and the second inverter is coupled to a third supply node, wherein the first supply node is coupled to a ground connection.

In Example 9, the subject matter of Examples 1-8 includes subject matter wherein the first input path includes a first additional inverter coupled in series with the first inverter, and the second input path includes a second additional inverter coupled in series with the second inverter, and wherein each of the first additional inverter and the second additional inverter is coupled either to the second supply node or to a fourth supply node.

In Example 10, the subject matter of Examples 1-9 includes subject matter wherein the first input path is configured to receive first input data having a first value, the second input path is configured to receive second input data having a second value.

In Example 11, the subject matter of Example 10 includes subject matter wherein the first value corresponds to binary one, and the second value corresponds to binary zero.

In Example 12, the subject matter of Example 1-11 includes subject matter wherein the apparatus comprises a system-on-chip (SoC), the SoC comprising an integrated circuit (IC), the IC comprising the driver.

In Example 13, the subject matter of Example 1-11, further comprises an integrated circuit chip and at least one connector coupled to the integrated circuit chip, the integrated circuit chip including the driver includes subject matter wherein the at least one connector conforms with at least one of Universal Serial Bus (USB), High-Definition Multimedia Interface (HDMI), Thunderbolt, Peripheral Component Interconnect Express (PCIe), Universal Chiplet Interconnect Express (UCIe), Ethernet, Double Data Rate (DDR) synchronous dynamic random-access memory link, Low-Power DDR (LPDDR), and Fiber Optic specifications.

Example 14 is electronic apparatus comprising a driver circuit including a first region including a first semiconductor material of a first conductivity type, a first additional region including a first additional semiconductor material of the first conductivity type, and a region between the first region and the first additional region and including a first semiconductor material of a second conductivity type, a second region including a second semiconductor material of the first conductivity type, a second additional region including a second additional semiconductor material of the first conductivity type, and a region between the second region and the second additional region and including a second semiconductor material of the second conductivity type, a third region including a third semiconductor material of the second conductivity type, a third additional region including a third additional semiconductor material of the second conductivity type, and a region between the third region and the third additional region and including a third semiconductor material of the first conductivity type, a conductive region separated from the region between the third region and the third additional region by a dielectric region, a conductive connection coupled to the second additional region and the third region, and a first supply node coupled to the first region and the conductive region, and a second supply node coupled to the third additional region

In Example 15, the subject matter of Example 14 includes subject matter wherein the first conductivity type is N-type, and the second conductivity type is P-type.

In Example 16, the subject matter of Examples 14-15 includes subject matter wherein the conductive region includes polysilicon.

In Example 17, the subject matter of Examples 14-16 includes subject matter wherein the conductive region includes metal.

In Example 18, the subject matter of Examples 14-17 includes subject matter wherein the first supply node is coupled to a positive voltage connection, and the second supply node is coupled to a ground connection.

Example 19 is process of making a driver of an electronic apparatus, comprising forming a first N-type transistor between a first supply node and an output node of the driver, forming a second N-type transistor between a node and the output node of the driver, forming a P-type transistor between the node and a second supply node, and forming a conductive connection between a gate of the P-type transistor and a ground connection.

In Example 20, the subject matter of Example 19 further comprising forming a first additional N-type transistor between the first supply node and the output node of the driver, forming a second additional N-type transistor between the node and the output node of the driver, forming an additional P-type transistor between the node and a second supply node, and forming an additional conductive connection between a gate of the additional P-type transistor and the ground connection.

Example 21 is method of operating a driver in an electronic apparatus, comprising providing first data to a first input path of the driver, the first input path coupled to a gate of a first N-type transistor of a pull-down path of the driver, providing second data to a second input path of the driver, the second input path coupled to a gate of a second N-type transistor of a pull-up path of the driver, wherein the pull-up path includes a P-type transistor coupled between the second N-type transistor and a supply node, and a gate of the P-type transistor coupled is coupled to a ground connection, and providing output data to an output node of the driver, the output node coupled to the pull-up path and the pull-down path.

In Example 22, the subject matter of Example 21 includes subject matter wherein the first data and the second data have different values.

Example 23 is an apparatus comprising at least one machine-readable medium including instructions that, when executed by processing circuitry, cause the processing circuitry to perform operations to implement any of Examples 1-22.

Example 24 is an apparatus comprising means to implement any of Examples 1-22.

Example 25 is system to implement any of Examples 1-22.

Example 26 is a method to implement any of Examples 1-22.

The above description is intended to be illustrative and not restrictive. For example, the above-described examples (or one or more aspects thereof) may be used in combination with others. Other embodiments may be used, such as by one of ordinary skill in the art upon reviewing the above description. The abstract is to allow the reader to ascertain the nature of the technical disclosure quickly. It is submitted with the understanding that it will not be used to interpret or limit the scope or meaning of the claims. Also, in the above detailed description, various features may be grouped to streamline the disclosure. However, the claims may not set forth every feature disclosed herein as embodiments may feature a subset of said features. Further, embodiments may include fewer features than those disclosed in a particular example. Thus, the following claims are hereby incorporated into the detailed description, with a claim standing on its own as a separate embodiment. The scope of the embodiments disclosed herein is to be determined regarding the appended claims, along with the full scope of equivalents to which such claims are entitled.

## Claims

1. An electronic apparatus comprising:
a first supply node;
a second supply node; and
a driver including:
a first input path, a second input path, and an output node;
a first N-type transistor including a gate coupled to the first input path, a first terminal coupled to the first supply node, and a second terminal coupled to the output node;
a second N-type transistor including a gate coupled to the second input path, a first terminal coupled to the output node, and a second terminal; and
a resistor coupled between the second terminal of the second N-type transistor and the second supply node.

2. The apparatus of claim 1, wherein the resistor includes a structure of a P-type transistor, the P-type transistor includes a gate coupled to the first supply node, a first terminal coupled to the second terminal of the second N-type transistor, and a second terminal coupled to the second supply node.

3. The apparatus of claim 2, wherein the P-type transistor has a size greater than a size of the second N-type transistor.

4. The apparatus of claim 1 or claim 3, wherein the second N-type transistor has a size greater than a size of the first N-type transistor.

5. The apparatus of claims 2-4, wherein the P-type transistor is configured to operate in a linear region.

6. The apparatus of claims 2-5, further comprising:
a first additional N-type transistor including a gate coupled to an additional supply node, a first terminal coupled to the first supply node, and a second terminal coupled to the output node;
a second additional N-type transistor including a gate coupled to the additional supply node, a first terminal coupled to the output node, and a second terminal; and
an additional P-type transistor including a gate coupled to the first supply node, a first terminal coupled to the second terminal of the second additional N-type transistor, and a second terminal coupled to the second supply node.

7. The apparatus of claims 1-6, wherein:
the first input path includes a first inverter; and
the second input path includes a second inverter.

8. The apparatus of claim 7, wherein each of the first inverter and the second inverter is coupled to a third supply node, wherein the first supply node is coupled to a ground connection.

9. The apparatus of claims 1-8, wherein:
the first input path includes a first additional inverter coupled in series with the first inverter; and
the second input path includes a second additional inverter coupled in series with the second inverter, wherein each of the first additional inverter and the second additional inverter is coupled either to the second supply node or to a fourth supply node.

10. The apparatus of claims 1-9, wherein the first input path is configured to receive first input data having a first value, the second input path is configured to receive second input data having a second value.

11. The apparatus of claim 10, wherein the first value corresponds to binary one, and the second value corresponds to binary zero.

12. The apparatus of claims 1-11, wherein the apparatus comprises a system-on-chip (SoC), the SoC comprising an integrated circuit (IC), the IC comprising the driver.

13. The apparatus of claims 1-11, further comprises an integrated circuit chip and at least one connector coupled to the integrated circuit chip, the integrated circuit chip including the driver, wherein the at least one connector conforms with at least one of Universal Serial Bus (USB), High-Definition Multimedia Interface (HDMI), Thunderbolt, Peripheral Component Interconnect Express (PCIe), Universal Chiplet Interconnect Express (UCIe), Ethernet, Double Data Rate (DDR) synchronous dynamic random-access memory link, Low-Power DDR (LPDDR), and Fiber Optic specifications.

14. A method of operating a driver in an electronic apparatus, comprising:
providing first data to a first input path of the driver, the first input path coupled to a gate of a first N-type transistor of a pull-down path of the driver;
providing second data to a second input path of the driver, the second input path coupled to a gate of a second N-type transistor of a pull-up path of the driver, wherein the pull-up path includes a P-type transistor coupled between the second N-type transistor and a supply node, and a gate of the P-type transistor coupled is coupled to a ground connection; and
providing output data to an output node of the driver, the output node coupled to the pull-up path and the pull-down path.

15. The method of claim 14, wherein the first data and the second data have different values.
